# EUROPEAN PATENT APPLICATION

(11) **EP 4 703 502 A1**
(43) Date of publication of application: **04.03.2026**
(21) Application number: 23935437.6
(22) Date of filing: 14.11.2023
(51) Int. Cl.: C30B 29/36, C30B 1/02, G01N 21/65, H01L 21/31, H01L 21/66

(54) **SIC SUBSTRATE AND SIC COMPOSITE SUBSTRATE**

(30) Priority: 27.04.2023 JP 2023073297
(71) Applicant: NGK Insulators, Ltd., Nagoya-shi, Aichi 467-8530 (JP)
(72) Inventor: MIYAKAZE Risa, Nagoya-shi, Aichi 467-8530 (JP); MATSUSHIMA Kiyoshi, Nagoya-shi, Aichi 467-8530 (JP); YOSHIKAWA Jun, Nagoya-shi, Aichi 467-8530 (JP)
(74) Representative: Müller-Boré & Partner Patentanwälte PartG mbB
(86) International application number: PCT/JP2023/040963
(87) International publication number: WO 2024/224665

(57) **Abstract**

There is provided a SiC substrate in which warp is small. The SiC substrate includes a biaxially oriented SiC layer, and, in a Si surface and a C surface of the SiC substrate, a difference between a maximum value kₘₐₓ and a minimum value kₘᵢₙ of a Raman shift value is 0.50 cm⁻¹ or less. The Raman shift value is obtained by, in the Si surface of the SiC substrate, measuring the Raman shift value indicating a peak corresponding to a transverse acoustic branch of a Raman spectrum at 1 mm intervals on two straight lines passing through a central point of the Si surface and being orthogonal to each other, and, in the C surface of the SiC substrate, measuring the Raman shift value indicating a peak corresponding to a transverse acoustic branch of a Raman spectrum at 1 mm intervals on two straight lines passing through a central point of the C surface and being orthogonal to each other.

## Description

### TECHNICAL FIELD

The present invention relates to a SiC substrate and a SiC composite substrate.

### BACKGROUND ART

SiC (silicon carbide) has attracted attention as a wide bandgap material capable of controlling large voltage and large electric power with low loss. In recent years in particular, power semiconductor devices using SiC materials (SiC power devices) are superior to those using Si semiconductors in terms of downsizing, low power consumption, and high efficiency, and therefore are expected to be utilized in various applications. For example, by adopting the SiC power devices, a converter, an inverter, an in-vehicle charger, and the like for an electric vehicle (EV) or a plug-in hybrid vehicle (PHEV) can be downsized, making it possible to improve efficiency. Accordingly, development of a SiC wafer, which is the basis of the SiC power device, has attracted a lot of attention.

To produce a SiC power device, SiC single crystals need to be epitaxially grown on a SiC substrate. However, warp sometimes occurs in the SiC substrate, and it is desired to suppress the warp. As an example in which the warp of the substrate is reduced, Patent Literature 1 (JP2022-120059A) discloses a SiC substrate that satisfies Δₘₐₓ - Δₘᵢₙ ≤ 0.14 when the maximum value and the minimum value of the half-width of the peak corresponding to the folded mode of the longitudinal optical branch of the Raman Spectrum of the SiC substrate are defined as Δₘₐₓ and Δₘᵢₙ, respectively. Patent Literature 2 (WO2021/111835A1) discloses a SiC substrate comprising a first main surface and a second main surface on the opposite side of the first main surface, wherein, when the average value of wave numbers indicating peaks corresponding to a folded mode of a longitudinal optical branch of a Raman spectrum of SiC in a first square region on the first main surface is defined as first wave number, and the average value of wave numbers indicating peaks corresponding to a folded mode of a longitudinal optical branch of a Raman spectrum of SiC in a second square region on the first main surface is defined as second wave number, the absolute value of a difference between the first wave number and the second wave number is 0.2 cm⁻¹ or less. Patent Literature 3 (JP2017-75074A) discloses a SiC substrate comprising a carbon surface-side main surface and a silicon surface-side main surface, wherein the SiC substrate has a 4H crystal structure, and wherein the nitrogen concentration in the carbon surface-side main surface is higher than the nitrogen concentration in the silicon surface-side main surface, and a difference between a Raman peak shift of the carbon surface-side main surface and a Raman peak shift of the silicon surface-side main surface is 0.2 cm⁻¹ or less. Patent Literature 4 (WO2017/057742A1) discloses a SiC single crystal ingot comprising a SiC single crystal formed on a seed crystal, wherein a Raman index of a difference (A-B) between a Raman shift value (A) measured at a center part of the substrate cut out from the ingot and a Raman shift value (B) measured at an edge part is 0.20 or less. Patent Literature 5 (JP2016-164120A) discloses a SiC single crystal wafer having a basal plane dislocation density of the surface of 100/cm² or more and 1000/cm² or less, a threading screw dislocation density of 160/cm² or more and 500/cm² or less, and a Raman index of 0.03 or more and 0.2 or less, and having a diameter of 150 mm or more and 300 mm or less.

### CITATION LIST

### PATENT LITERATURE

Patent Literature 1: JP2022-120059A
Patent Literature 2: WO2021/111835A1
Patent Literature 3: JP2017-75074A
Patent Literature 4: WO2017/057742A1
Patent Literature 5: JP2016-164120A

### SUMMARY OF INVENTION

As described above, methods for reducing warp of a substrate have been studied, but further improvement is in demand. In particular, warp of a SiC substrate is a problem when the SiC substrate is polished after epitaxial film forming and when a semiconductor apparatus is manufactured. Specifically, breakings occur when the SiC substrate is adhered to the polishing board, and poor chucking occurs when the SiC substrate is chucked in the manufacturing process of the semiconductor.

The present inventors have now discovered that, by controlling the Raman shift value indicating a peak corresponding to the transverse acoustic branch of the Raman spectrum in the SiC substrate, warp of the SiC substrate can be reduced.

Therefore, it is an object of the present invention to provide a SiC substrate in which the warp is small.

The present invention provides the following aspects:

### [Aspect 1]

A SiC substrate comprising a biaxially oriented SiC layer,
wherein, in a Si surface and a C surface of the SiC substrate, a difference between a maximum value kₘₐₓ and a minimum value kₘᵢₙ of a Raman shift value is 0.50 cm⁻¹ or less, and
wherein, the Raman shift value is obtained by, in the Si surface of the SiC substrate, measuring the Raman shift value indicating a peak corresponding to a transverse acoustic branch of a Raman spectrum at 1 mm intervals on two straight lines passing through a central point of the Si surface and being orthogonal to each other, and, in the C surface of the SiC substrate, measuring the Raman shift value indicating a peak corresponding to a transverse acoustic branch of a Raman spectrum at 1 mm intervals on two straight lines passing through a central point of the C surface and being orthogonal to each other.

### [Aspect 2]

The SiC substrate according to aspect 1, wherein the difference between the maximum value kₘₐₓ and the minimum value kₘᵢₙ is 0.20 cm⁻¹ or less.

### [Aspect 3]

The SiC substrate according to aspect 1 or 2, wherein a N concentration of the biaxially oriented SiC layer is 5.0 × 10¹⁸ atoms/cm³ or more.

### [Aspect 4]

The SiC substrate according to any one of aspects 1 to 3, wherein a rare earth element concentration of the biaxially oriented SiC layer is 1.0 × 10¹⁴ to 5.0 × 10¹⁵ atoms/cm³.

### [Aspect 5]

A SiC composite substrate comprising:
a SiC single crystal substrate; and
the SiC substrate according to any one of aspects 1 to 4 on the SiC single crystal substrate.

### BRIEF DESCRIPTION OF DRAWINGS

Figure 1 is a longitudinal cross-sectional view of a SiC composite substrate 10.
Figure 2 is a diagram showing a process of manufacturing the SiC composite substrate 10.
Figure 3 is a conceptual diagram showing the configuration of an aerosol deposition (AD) apparatus 50.
Figure 4 is a top view of a SiC substrate 10 for describing a measurement method for the amount of warp of the SiC substrate 10.
Figure 5 is a schematic cross-sectional view of a SiC substrate 10 for describing a measurement method for the amount of warp of the SiC substrate 10.
Figure 6 is a schematic cross-sectional view of a SiC substrate 10 for describing a measurement method for the amount of warp of the SiC substrate 10.

### DESCRIPTION OF EMBODIMENTS

### SiC Substrate

A SiC substrate according to the present invention is a SiC substrate comprising a biaxially oriented SiC layer. In the SiC substrate, in a Si surface and a C surface, a difference between a maximum value kₘₐₓ and a minimum value kₘᵢₙ of the Raman shift value is 0.50 cm⁻¹ or less. Here, the Raman shift value is obtained by, in the Si surface of the SiC substrate, measuring the Raman shift value indicating a peak corresponding to a transverse acoustic branch of a Raman spectrum at 1 mm intervals on two straight lines passing through a central point of the Si surface and being orthogonal to each other, and, in the C surface of the SiC substrate, measuring the Raman shift value indicating a peak corresponding to a transverse acoustic branch of a Raman spectrum at 1 mm intervals on two straight lines passing through a central point of the C surface and being orthogonal to each other. The Si surface and the C surface of the SiC substrate refer to, where the SiC substrate is composed of a biaxially oriented SiC layer, the Si surface and the C surface of the biaxially oriented SiC layer, and where the SiC substrate is a composite substrate comprising a biaxially oriented SiC layer and a SiC single crystal substrate, the Si surface and the C surface of the composite substrate (in this case, the surface of the biaxially oriented SiC layer and the surface of the SiC single crystal substrate may be the Si surface and the C surface, respectively, or the surface of the biaxially oriented SiC layer and the surface of the SiC single crystal substrate may be the C surface and the Si surface, respectively). The Raman shift value indicating a peak corresponding to a transverse acoustic branch of a Raman spectrum typically means a Raman shift value indicating a peak of FTA (2/4)E₂ (wave numbers of around 200 cm⁻¹). Thus, by controlling the Raman shift value indicating a peak corresponding to the transverse acoustic branch of the Raman spectrum in the SiC substrate, warp of the SiC substrate can be reduced.

As described above, warp sometimes occurs in the SiC substrate, and it is desired to suppress the warp, but suppression of warp by conventional methods is insufficient, and further improvement of warp is in demand. In this respect, according to the present invention, the problem is conveniently solved. In particular, controlling the Raman shift value indicating a peak corresponding to the transverse acoustic branch of the Raman spectrum in the SiC substrate means that the in-plane distribution of nitrogen and the elastic strain distribution in the SiC substrate can be reduced. It is considered that, by reducing the in-plane distribution of nitrogen and the elastic strain distribution in the SiC substrate, warp of the SiC substrate can be reduced.

In the SiC substrate of the present invention, when the Raman shift value indicating a peak corresponding to a transverse acoustic branch of a Raman spectrum is measured in the Si surface and the C surface, the difference between the maximum value kₘₐₓ and the minimum value kₘᵢₙ of the obtained Raman shift value is 0.50 cm⁻¹ or less and preferably 0.20 cm⁻¹ or less. As described above, in the Si surface of the SiC substrate, the Raman shift value indicating a peak corresponding to a transverse acoustic branch of a Raman spectrum is measured at 1 mm intervals on two straight lines passing through a central point of the Si surface and being orthogonal to each other, and, in the C surface of the SiC substrate, the Raman shift value indicating a peak corresponding to a transverse acoustic branch of a Raman spectrum is measured at 1 mm intervals on two straight lines passing through a central point of the C surface and being orthogonal to each other. The difference between the maximum value kₘₐₓ and the minimum value kₘᵢₙ of the Raman shift value thus obtained can be regarded as the difference between the maximum value and the minimum value of the Raman shift value as measured in the entire surface (entire area) of the SiC substrate.

The SiC substrate or the biaxially oriented SiC layer has an off angle, and the off angle is preferably 0.1 to 12°, and more preferably 1 to 5° from the [0001] axis of the SiC substrate or the biaxially oriented SiC layer.

Examples of the rare earth element contained in the biaxially oriented SiC layer include Y, La, Ce, Pr, Nd, Pm, Sm, Eu, Gd, Tb, Dy, Ho, Er, Tm, Yb, Lu, Sc, and combinations thereof. The rare earth element is preferably Y or Ce from the viewpoint of reducing warp of the substrate, and Y is more preferable.

The rare earth element concentration in the biaxially oriented SiC layer is preferably 1.0 × 10¹⁴ to 5.0 × 10¹⁵ atoms/cm³, more preferably 5.0 × 10¹⁴ to 5.0 × 10¹⁵ atoms/cm³, and further preferably 5.0 × 10¹⁴ to 1.4 × 10¹⁵ atoms/cm³.

The N concentration of the biaxially oriented SiC layer is preferably 1.0 × 10¹⁸ atoms/cm³ or more, more preferably 5.0 × 10¹⁸ atoms/cm³ or more, and further preferably 8.0 × 10¹⁸ atoms/cm³ or more. The upper limit of the N concentration is not particularly limited, but is preferably 1.0 × 10²¹ atoms/cm³ or less, more preferably 1.0 × 10²⁰ atoms/cm³ or less, and further preferably 1.0 × 10¹⁹ atoms/cm³ or less.

The biaxially oriented SiC layer is preferably oriented in the c-axis direction and the a-axis direction. In addition, the SiC substrate is preferably composed of the biaxially oriented SiC layer. The biaxially oriented SiC layer may be a SiC single crystal, a SiC polycrystal, or a mosaic crystal as long as the biaxially oriented SiC layer is oriented in the biaxial directions of the c-axis direction and the a-axis direction. The mosaic crystal refers to an aggregate of crystals not having clear grain boundaries but being such that the orientation directions of the crystals are slightly different from one or both of the c-axis and the a-axis. The method for evaluating the orientation is not particularly limited, but known analysis methods such as an EBSD (Electron Back Scatter Diffraction Patterns) method and an X-ray pole figure can be used. For example, when the EBSD method is used, inverse pole figure mapping of a surface (plate surface) of the biaxially oriented SiC layer or a section orthogonal to the plate surface is measured. When the following four conditions are satisfied in the resultant inverse pole figure mapping, the SiC layer can be defined as being biaxially oriented in an approximate normal direction and an approximate plate surface direction: (A) the SiC layer is oriented in a particular direction (the first axis) in an approximate normal direction of the plate surface; (B) the SiC layer is oriented in a particular direction (the second axis) in an approximate in-plate-surface direction, the direction orthogonal to the first axis; (C) tilt angles from the first axis are distributed within ±10°; and (D) tilt angles from the second axis are distributed within ±10°. In other words, when the four conditions are satisfied, the SiC layer is determined to be biaxially oriented along the c-axis and the a-axis. For example, when the approximate normal direction of the plate surface is oriented along the c-axis, the approximate in-plate-surface direction only needs to be oriented in a particular direction (for example, the a-axis) orthogonal to the c-axis.

The biaxially oriented SiC layer only needs to be biaxially oriented in the approximate normal direction and the approximate in-plate-surface direction, but the approximate normal direction is preferably oriented along the c-axis direction. As a tilt angle distribution in the approximate normal direction and/or the approximate in-plate-surface direction is smaller, the mosaicity of the biaxially oriented SiC layer is smaller, and as the tilt angle distribution is closer to zero, the biaxially oriented SiC layer is closer to a single crystal. Therefore, in view of the crystallinity of the biaxially oriented SiC layer, the tilt angle distribution is preferably smaller in both the approximate normal direction and the approximate plate surface direction, more preferably, for example, ±5° or less, and further preferably ±3° or less.

### SiC Composite Substrate

The SiC substrate of the present invention is preferably in the form of a SiC composite substrate. That is, according to a preferable embodiment of the present invention, a SiC composite substrate comprising a SiC single crystal substrate and the above-described SiC substrate on the SiC single crystal substrate is provided. Thus, when the SiC composite substrate comprises a SiC substrate in which the Raman shift value indicating a peak corresponding to the transverse acoustic branch of the Raman spectrum is controlled, warp of the SiC composite substrate can be reduced.

The SiC single crystal substrate is typically a layer composed of a SiC single crystal and has a crystal growth surface. The polytype and off angle of the SiC single crystal are not particularly limited, but the polytype is preferably 4H or 6H, and the off angle is preferably 0.1 to 12° from the [0001] axis of the single crystal SiC. More preferably, the polytype is 4H, and the off angle is 1 to 5° from the [0001] axis of the single crystal SiC.

The SiC substrate of the present invention may be in the form of a self-supporting substrate consisting of a biaxially oriented SiC layer or may be in the form of a SiC composite substrate with a SiC single crystal substrate. Therefore, the biaxially oriented SiC layer may be finally separated from the SiC single crystal substrate as necessary. The separation of the SiC single crystal substrate may be performed by a known method and is not particularly limited. Examples of the known method include a method of separating the biaxially oriented SiC layer with a wire saw, a method of separating the biaxially oriented SiC layer by electro discharge machining, and a method of separating the biaxially oriented SiC layer utilizing laser. In an embodiment in which the biaxially oriented SiC layer is epitaxially grown on a SiC single crystal substrate, the biaxially oriented SiC layer may be installed on another support substrate after the SiC single crystal substrate is separated. The material of the another support substrate is not particularly limited and suitable one may be selected in view of physical properties of the material. In view of thermal conductivity for example, examples of the material include metal substrates such as a Cu substrate and ceramic substrates such as a SiC substrate and an AIN substrate.

### Method for Manufacturing SiC Composite Substrate

The SiC composite substrate comprising the SiC substrate of the present invention can be preferably manufactured by (a) forming a predetermined orientation precursor layer on a SiC single crystal substrate, (b) subjecting the orientation precursor layer to heat treatment on the SiC single crystal substrate to convert at least a portion of the orientation precursor layer near the SiC single crystal substrate into a SiC substrate (biaxially oriented SiC layer), and, optionally, (c) performing processing such as grinding or polishing to expose the surface of the biaxially oriented SiC layer. However, the method for manufacturing the SiC composite substrate is not limited as long as a SiC substrate in which the Raman shift value indicating a peak corresponding to the transverse acoustic branch of the Raman spectrum is controlled can be obtained. For example, the method is preferably a method in which a treatment for accelerating the flow speed of nitrogen during heat treatment is possible, and, in that case, vapor phase methods such as CVD and a sublimation method may be adopted, or liquid phase methods such as a solution method may be adopted. The rare earth element concentration and/or the N concentration in the SiC substrate (biaxially oriented SiC layer) can be preferably controlled by adding a rare earth compound to the raw material at the time of formation of the orientation precursor layer or changing the heat treatment conditions (for example, the flow rate of gas, the heat treatment temperature, and the holding time). In accordance with such manufacturing methods, a satisfactory SiC substrate in which the Raman shift value indicating a peak corresponding to the transverse acoustic branch of the Raman spectrum is controlled can be produced, whereby warp of the SiC substrate or the SiC composite substrate using the SiC substrate can effectively be reduced.

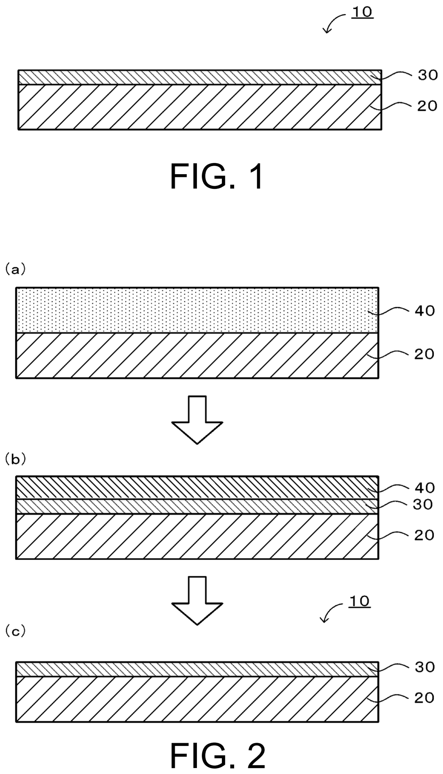

Hereinafter, a preferred method for manufacturing the SiC composite substrate will be described. Figure 1 is a longitudinal cross-sectional view of a SiC composite substrate 10 (a cross-sectional view obtained by cutting the SiC composite substrate 10 vertically along a plane including the central axis of the SiC composite substrate 10). Figure 2 is a diagram showing a process of manufacturing the SiC composite substrate 10.

As shown in Figure 1, the SiC composite substrate 10 of the present embodiment comprises: a SiC single crystal substrate 20; and a SiC substrate 30 on the SiC single crystal substrate.

### (a) Process of Forming Orientation Precursor Layer

As shown in Figure 2(a), an orientation precursor layer 40 is made into the SiC substrate (biaxially oriented SiC layer) 30 by heat treatment, which will be described later. In the process of forming the orientation precursor layer 40, the orientation precursor layer 40 is formed on a crystal growth surface of the SiC single crystal substrate 20.

As the method for forming the orientation precursor layer 40, a known method can be adopted. Examples of the method for forming the orientation precursor layer 40 include solid phase film deposition methods such as an AD (Aerosol Deposition) method and a HPPD (Hypersonic Plasma Particle Deposition) method, vapor phase film deposition methods such as a sputtering method, a vapor deposition method, a sublimation method, and various CVD (Chemical Vapor Deposition) methods, and liquid phase film deposition methods such as a solution growth method, and a method of directly forming the orientation precursor layer 40 on the SiC single crystal substrate 20 can be used. As the CVD method, for example, a thermal CVD method, a plasma CVD method, a mist CVD method, and a MO (Metal Organic) CVD method can be used. Further, it is also possible to use a method in which a polycrystalline substance previously produced by a sublimation method, any of various CVD methods, sintering, or the like is used as the orientation precursor layer 40, and the polycrystalline substance is placed on the SiC single crystal substrate 20. Alternatively, the method for forming the orientation precursor layer 40 may also be a method in which a green body of the orientation precursor layer 40 is preliminarily produced, and this green body is placed on the SiC single crystal substrate 20. Such an orientation precursor layer 40 may be tape green body produced by tape casting or a green compact produced by pressure forming such as uniaxial pressing.

In forming these orientation precursor layers 40, a rare earth compound is preferably contained in the raw materials for the orientation precursor layers 40. Thus, the concentration of the rare earth compound in the biaxially oriented SiC layer can be controlled. Examples of the rare earth compound include, but are not particularly limited to, an oxide, a nitride, a carbide, and a fluoride of at least one rare earth element among the 17 rare earth elements described above. As the rare earth compound, an oxide of a rare earth element is preferable.

When any of various CVD methods, a sublimation method, a solution growth method, or the like is used in the method of directly forming the orientation precursor layer 40 on the SiC single crystal substrate 20, epitaxial growth may occur on the SiC single crystal substrate 20 without a heat treatment process, which will be described later, so that the SiC substrate 30 may be deposited. However, the orientation precursor layer 40 is preferably not oriented, specifically is preferably an amorphous or non-oriented polycrystal, at the time of formation, and is preferably oriented using a SiC single crystal as a seed in the heat treatment process in a later stage. Thus, crystal defects that reach the surface of the SiC substrate 30 can be effectively reduced. The reason for this is not certain, but it is considered that the solid phase orientation precursor layer once deposited causes rearrangement of the crystal structure using a SiC single crystal as a seed, and this may also have an effect in disappearance of crystal defects. Therefore, when any of various CVD methods, a sublimation method, a solution growth method, or the like is used, it is preferred to select conditions that do not cause epitaxial growth to occur in the process of forming the orientation precursor layer 40.

However, the method for forming the orientation precursor layer 40 is preferably a method of directly forming the orientation precursor layer 40 on the SiC single crystal substrate 20 by an AD method or any of various CVD methods, or a method of placing a polycrystalline substance on the SiC single crystal substrate 20, wherein the polycrystalline substance is separately produced by a sublimation method, any of various CVD methods, sintering, or the like. The use of these methods makes it possible to form the orientation precursor layer 40 in a relatively short time. The AD method is particularly preferred because a high-vacuum process is unnecessary, and the film deposition rate is relatively high. In the method using a previously produced polycrystalline substance as the orientation precursor layer 40, ingenuity such as making the surface of the polycrystalline substance sufficiently smooth in advance is necessary in order to enhance the adhesion between the polycrystalline substance and the SiC single crystal substrate 20. Therefore, the method of directly forming the orientation precursor layer 40 is preferred in view of cost. The method of placing a previously produced green body on the SiC single crystal substrate 20 is also preferred as a simple method, but the orientation precursor layer 40 is composed of a powder, and therefore a sintering process is necessary in the heat treatment process, which will be described later. Known conditions can be used in any of the methods, but hereinafter, description will be made on the method of directly forming the orientation precursor layer 40 on the SiC single crystal substrate 20 by an AD method or a thermal CVD method and the method of placing a previously produced green body on the SiC single crystal substrate 20.

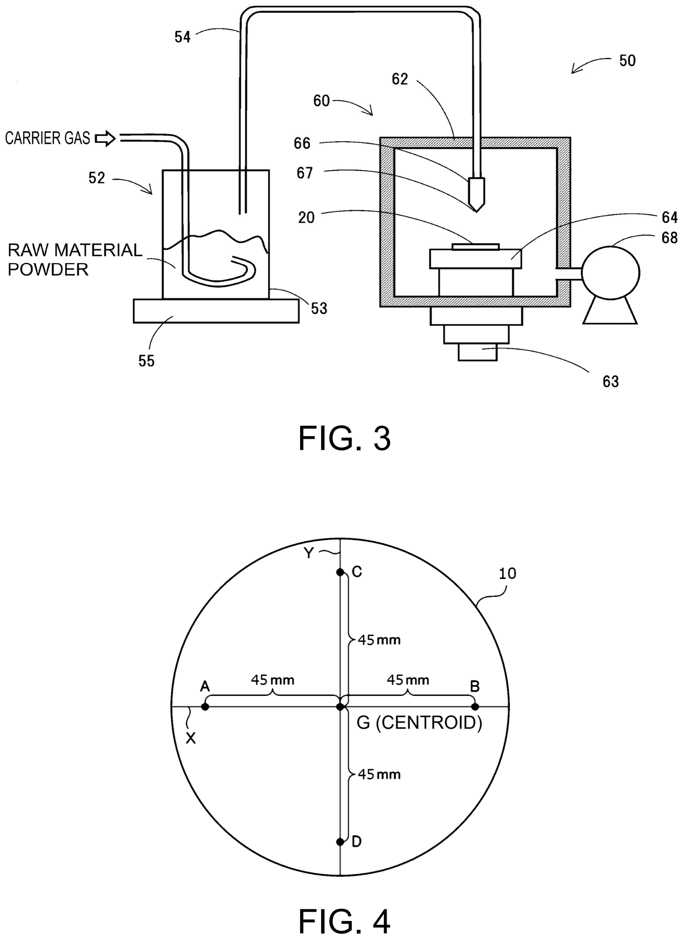

The AD method is a technique such that fine particles or fine particle raw materials are mixed with a gas to form aerosol, and this aerosol is jetted at a high speed from a nozzle to allow the aerosol to collide with a substrate to form a coat and has a characteristic that the coat can be formed at normal temperature. Figure 3 shows an example of a film deposition apparatus (AD apparatus) that is used in such an AD method. An AD apparatus 50 shown in Figure 3 is configured as an apparatus that is used in an AD method in which a raw material powder is jetted onto a substrate in an atmosphere where the air pressure is lower than the atmospheric pressure. This AD apparatus 50 comprises: an aerosol generation unit 52 that generates aerosol of a raw material powder containing raw material components; and a film deposition unit 60 that jets the raw material powder onto the SiC single crystal substrate 20 to form a film containing the raw material components. The aerosol generation unit 52 comprises: an aerosol generation chamber 53 that receives supply of a carrier gas from a gas cylinder that stores the raw material powder, the gas cylinder not shown, to generate aerosol; a raw material supply pipe 54 that supplies generated aerosol to the film deposition unit 60; and a vibration exciter 55 that gives vibration of a frequency of 10 to 100 Hz to the aerosol generation chamber 53 and the aerosol therein. The film deposition unit 60 comprises: a film deposition chamber 62 that jets the aerosol onto the SiC single crystal substrate 20; a substrate holder 64 that is fixedly set up inside the film deposition chamber 62 to fix the SiC single crystal substrate 20; and an X-Y stage 63 that moves the substrate holder 64 in the X-axis and Y-axis directions. Further, the film deposition unit 60 comprises: a jet nozzle 66 that has a slit 67 formed at the tip and jets the aerosol onto the SiC single crystal substrate 20; and a vacuum pump 68 that reduces the pressure in the film deposition chamber 62. The jet nozzle 66 is attached to the tip of the raw material supply pipe 54.

The AD method is known to generate pores in a film or make a film into a green compact depending on the film deposition conditions. For example, the AD method is susceptible to the collision speed of the raw material powder onto the substrate, the particle size of the raw material powder, the aggregation state of the raw material powder in the aerosol, the jetting amount per unit time, and the like. The collision speed of the raw material powder onto the substrate is influenced by the differential pressure between the inside of the film deposition chamber 62 and the inside of the jet nozzle 66, the opening area of the jet nozzle, and the like. Therefore, to obtain a dense orientation precursor layer, these factors need to be controlled properly.

In the thermal CVD method, known film deposition apparatuses such as commercially available film deposition apparatuses can be utilized as a film deposition apparatus. The raw material gas is not particularly limited, and a silicon tetrachloride (SiCl₄) gas and a silane (SiH₄) gas as a supply source of Si, and a methane (CH₄) gas, a propane (C₃H₈) gas, and the like as a supply source of C can be used. The film deposition temperature is preferably 1000 to 2200°C, more preferably 1100 to 2000°C, and further preferably 1200 to 1900°C.

When the film is deposited on the SiC single crystal substrate 20 using the thermal CVD method, it is known that epitaxial growth may occur on the SiC single crystal substrate 20 to form the SiC substrate 30. However, the orientation precursor layer 40 is preferably not oriented, specifically is preferably an amorphous or non-oriented polycrystal, at the time of production, and it is preferred to allow rearrangement of the crystals to occur using a SiC single crystal as a seed crystal during the heat treatment process. The film deposition temperature, the flow rates of gases such as a Si source and a C source and the ratio thereof, the film deposition pressure, and the like are known to give influences in forming an amorphous or polycrystal layer on a SiC single crystal using the thermal CVD method. The influence of the film deposition temperature is large, and in view of forming an amorphous or polycrystal layer, the film deposition temperature is preferably lower, preferably lower than 1700°C, more preferably 1500°C or lower, and further preferably 1400°C or lower. However, when the film deposition temperature is too low, the film deposition rate itself is also lowered, and therefore the film deposition temperature is preferably higher in view of the film deposition rate.

When a previously produced green body is used as the orientation precursor layer 40, the green body can be produced by forming a raw material powder for the orientation precursor. For example, when press forming is used, the orientation precursor layer 40 is a press-formed green body. The press-formed green body can be produced by subjecting the raw material powder for the orientation precursor to press forming based on a known method and may be produced by, for example, putting the raw material powder into a metal mold and pressing the raw material powder at a pressure of preferably 100 to 400 kgf/cm², and more preferably 150 to 300 kgf/cm². The forming method is not particularly limited, and tape casting, extrusion forming, slip casting, and a doctor blade method, and optional combinations thereof can be used in addition to press forming. For example, when tape casting is used, additives such as a binder, a plasticizer, a dispersant, and a dispersion medium are appropriately added to the raw material powder to make a slurry, and this slurry is preferably allowed to pass through a slit-like thin ejection port to be ejected and formed into a sheet. The thickness of the green body formed into a sheet is not limited but is preferably 5 to 500 µm in view of handling. When a thick orientation precursor layer is necessary, a plurality of the sheet green bodies may be stacked into a desired thickness for use. A portion of these green bodies near the SiC single crystal substrate 20 is made into the SiC substrate 30 by the subsequent heat treatment on the SiC single crystal substrate 20. In such a method, the green bodies need to be sintered in the heat treatment process, which will be described later. The SiC substrate 30 is preferably formed after the green bodies are subjected to the process in which the green bodies are sintered and integrated as a polycrystalline substance with the SiC single crystal substrate 20. When the green bodies do not undergo a sintered state, epitaxial growth using a SiC single crystal as a seed may occur insufficiently. Therefore, the green body may contain an additive such as a sintering aid in addition to the SiC raw material.

### (b) Heat Treatment Process

As shown in Figure 2(b), in the heat treatment process, a laminate in which the orientation precursor layers 40 are laminated or placed on the SiC single crystal substrate 20 are subjected to heat treatment to generate the SiC substrate 30. The heat treatment method is not particularly limited as long as epitaxial growth using the SiC single crystal substrate 20 as a seed occurs, and can be performed in a known heat treatment furnace such as a tube furnace or a hot plate. Not only heat treatment under normal pressure (pressless heat treatment) but also heat treatment under pressure such as hot pressing and HIP and a combination of the heat treatment under normal pressure and the heat treatment under pressure can be used. The atmosphere of the heat treatment is preferably an atmosphere of inert gas containing nitrogen. The inert gas containing nitrogen is preferably a mixed gas containing nitrogen and argon, and the flow speed of the nitrogen during the heat treatment is, for example, 0.5 to 15 L/min, and the flow speed of the argon during the heat treatment is, for example, 3 to 100 L/min. The heat treatment temperature is preferably 1700 to 2700°C. By increasing the temperature, the orientation precursor layer 40 is likely to grow using the SiC single crystal substrate 20 as a seed crystal while being oriented along the c-axis and the a-axis. Therefore, the heat treatment temperature is preferably 1700°C or higher, more preferably 1800°C or higher, further preferably 1900°C or higher, and particularly preferably 2200°C or higher. On the other hand, when the temperature is excessively high, there is a possibility that part of SiC is lost by sublimation or SiC is plastically deformed to cause a defect such as, for example, a warp. Therefore, the heat treatment temperature is preferably 2700°C or lower, and more preferably 2500°C or lower. However, the heat treatment conditions give an influence on the content of rare earth elements in the biaxially oriented SiC layer, and therefore it is preferred to appropriately control the conditions (for example, the heat treatment temperature and holding time). From such viewpoints, the heat treatment temperature is preferably 1900 to 2700°C, more preferably 2200 to 2600°C, and further preferably 2400 to 2500°C. The holding time is preferably 2 to 30 hours, and more preferably 4 to 20 hours. Furthermore, the heat treatment temperature and the holding time have a relationship with the thickness of the SiC substrate 30 generated by epitaxial growth and can be appropriately adjusted.

However, a previously produced green body, when used as the orientation precursor layer 40, needs to be sintered during the heat treatment, and normal pressure firing at a high temperature, hot pressing, HIP, or a combination thereof is suitable. For example, when hot pressing is used, the surface pressure is preferably 50 kgf/cm² or higher, more preferably 100 kgf/cm² or higher, and further preferably 200 kgf/cm² or higher, and there is no upper limit in particular. In addition, the firing temperature is not particularly limited as long as sintering and epitaxial growth occur. However, the firing conditions give an influence on the content of the rare earth element in the biaxially oriented SiC layer, and therefore it is preferred to appropriately control the conditions (for example, the firing temperature and holding time). From such viewpoints, the firing temperature is preferably 1700 to 2700°C. The holding time is preferably 2 to 18 hours. The atmosphere during the firing can be selected from vacuum, nitrogen, and inert gas, or a mixed gas of nitrogen and an inert gas. Also, the firing may be performed in a plurality of steps, and the firing temperature and the total holding time are preferably within the above range. The SiC powder which is a raw material may be composed of at least one of an α-SiC powder and a β-SiC powder, but the SiC powder is preferably composed of a β-SiC powder. The SiC powder is preferably composed of SiC particles having an average particle size of 0.01 to 100 µm. The average particle size refers to an average value obtained when the powder is observed with a scanning electron microscope to measure the maximum sizes in a constant direction for 100 primary particles.

In the heat treatment process, the crystals in the orientation precursor layer 40 grow while being oriented along the c-axis and the a-axis from the crystal growth surface of the SiC single crystal substrate 20, and therefore the orientation precursor layer 40 is gradually changed into the SiC substrate 30 from the crystal growth surface. The SiC composite substrate comprising the generated SiC substrate 30 is such that the Raman shift value indicating a peak corresponding to the transverse acoustic branch of the Raman spectrum is controlled and warp has been reduced. The clear mechanism on the reason thereof is unknown, but it is considered that, for example, by accelerating the flow speed of the nitrogen during the heat treatment, the evenness of the nitrogen concentration and the heat distribution increases, thereby reducing the warp.

### (c) Grinding and/or Polishing Process

As shown in Figure 2(c), in the grinding process, the orientation precursor layer 40 left on the SiC substrate 30 after the heat treatment process is ground away to expose the surface of the SiC substrate 30, and the exposed surface is subjected to grinding and/or polishing. Thus, the SiC composite substrate 10 is obtained.

The present invention is not limited to the above-described embodiments, and it is needless to say that that the present invention can be conducted in various aspects as long as they belong to the technical scope of the present invention. For example, in the above-described embodiment, only one layer of the SiC substrate 30 is provided on the SiC single crystal substrate 20, but two or more layers may be provided. Specifically, by stacking the orientation precursor layer 40 on the SiC substrate 30 of the SiC composite substrate 10, performing heat treatment, and then performing grinding and/or polishing in the mentioned order, the SiC substrate 30 as the second layer can be provided on the SiC substrate 30.

### EXAMPLES

The present invention will be more specifically described by the following examples.

### Example 1

### (1) Production of Orientation Precursor Layer

A raw material powder containing 93.0% by weight of a commercially available β-SiC fine powder (volume-based D50 particle size: 0.7 µm), and 7.0% by weight of an yttrium oxide powder (volume-based D50 particle size: 0.1 µm) was provided. This raw material powder was mixed with a ball mill using SiC balls in ethanol for 24 hours, and the resultant mixture was dried to obtain a mixed powder. As a SiC single crystal layer, a commercially available SiC single crystal substrate (n-type 4H-SiC, diameter 100 mm (4 inches), Si surface, (0001) plane, off angle 4°, thickness 0.35 mm, without an orientation flat) was provided, and the mixed powder was jetted onto the SiC single crystal substrate in the AD apparatus 50 shown in Figure 3 to form an AD film (orientation precursor layer).

Conditions for depositing the AD film were as follows. Firstly, He was used as a carrier gas, and the film was deposited using a nozzle made of a ceramic and being such that a slit of 5 mm in long side × 0.4 mm in short side was formed. The condition for scanning the nozzle was as follows. The scan speed was set to 0.5 mm/s, the following scans were repeated: moving the nozzle 105 mm in a vertical and advancing direction with respect to the long side of the slit; moving the nozzle 5 mm in the long side direction of the slit; moving the nozzle 105 mm in a vertical and returning direction with respect to the long side of the slit; and moving the nozzle 5 mm in the long side direction of the slit and the opposite direction to the initial position, at the time when the nozzle was moved 105 mm from the initial position in the long side direction of the slit, scans were conducted in directions opposite to the previous directions to return the nozzle to the initial position, and this cycle was defined as one cycle, and this cycle was repeated up to 4000 cycles. The AD film thus formed had a thickness of about 400 µm.

### (2) Heat Treatment of Orientation Precursor Layer

The SiC single crystal substrate on which the AD film, which is the orientation precursor layer, was formed was taken out of the AD apparatus, and annealed in a mixed gas of argon and nitrogen at 2400°C for 10 hours. In other words, the orientation precursor layer was subjected to heat treatment to form a heat-treated layer. The flow speed of the argon was set to 4.5 L/min, and the flow speed of the nitrogen was set to 0.5 L/min.

### (3) Grinding

### (3a) Surface Grinding

A (0001) plane of the SiC single crystal substrate including a heat-treated layer formed thereon was subjected to surface grinding with a grinder (diamond wheel of #1000 to 6000) to a predetermined thickness to achieve a targeted thickness and surface state.

### (3b) Bottom Surface Grinding

A (000-1) plane of the SiC single crystal substrate including a heat-treated layer formed thereon was subjected to surface grinding with a grinder (diamond wheel of #1000 to 6000) to a predetermined thickness to achieve a targeted thickness and surface state.

### (4) Polishing

A (0001) plane and a (000-1) plane of the SiC single crystal substrate including a heat-treated layer formed thereon were each subjected to polishing using diamond abrasive grains, and then the (0001) plane was subjected to a CMP (Chemical Mechanical Polishing) finish into a targeted thickness and surface state. Thus, a SiC substrate was obtained.

### (5) Raman Spectrometry

A Raman shift value indicating a peak corresponding to a transverse acoustic branch of a Raman spectrum was measured at 1 mm intervals on two straight lines passing through a central point of the (0001) plane of the obtained SiC substrate (that is, the Si surface) and being orthogonal to each other. Also, a Raman shift value indicating a peak corresponding to a transverse acoustic branch of a Raman spectrum was measured at 1 mm intervals on two straight lines passing through a central point of the (000-1) plane of the obtained SiC substrate (that is, the C surface) and being orthogonal to each other. The measurement conditions are shown below. The difference (kₘₐₓ - kₘᵢₙ) between the maximum value kₘₐₓ and the minimum value kₘᵢₙ of the Raman shift values measured on these 4 straight lines was calculated. The results were as shown in Table 1. The Raman shift value indicating a peak corresponding to a transverse acoustic branch of a Raman spectrum means a Raman shift value indicating a peak of FTA (2/4)E₂ (wave numbers of around 200 cm⁻¹).

### <Conditions for Raman Spectrometry>

· Measurement apparatus: LabRAM HR Evolution manufactured by HORIBA, Ltd.
· Light source: diode-pumped solid-state laser (DPSS; 532 nm; 100 mW)
· Diffraction grating: 1800 gr/mm
· Optical system: backscattering geometry
· Objective lens: 100x
· Laser irradiation time: 5 seconds

### (6) Measurement of Warp

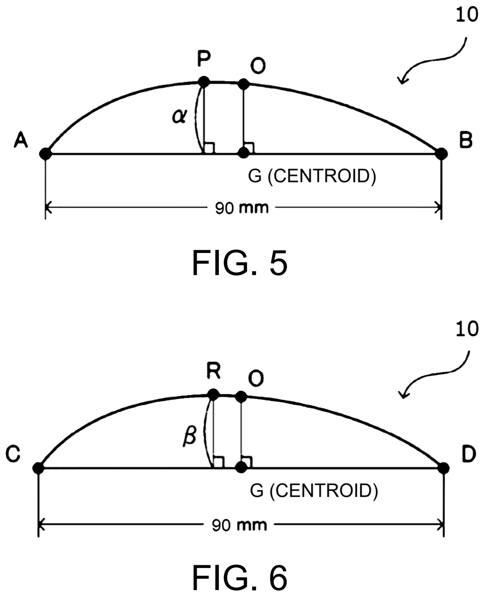

The surface of the obtained SiC substrate was measured for the degree of warp, that is, the amount of warp, using a high-accuracy laser measurement device (LT-9010M manufactured by KEYENCE CORPORATION). As illustrated in Figure 4, in the plan view diagram of the (0001) plane of the SiC substrate 10, two straight lines X and Y passing through a point G, which is the centroid of the plan view diagram, and being orthogonal to each other were drawn, and two points A and B, each being 45 mm away from the point G on the straight line X, and two points C and D, each being 45 mm away from the point G on the straight line Y, were determined. Next, as illustrated in Figure 5, a point P on a curved line AB was determined so that, among line segments extending perpendicularly to the line segment AB from an arbitrary point on the curved line AB between the points A and B on the surface of the SiC substrate 10, the distance of the line segment was the longest (for example, in Figure 5, there are points such as points P and O as arbitrary points on the curved line AB, and among the line segments extending perpendicularly to the line segment AB from respective points, the line segment extending from the point P is the longest). Then, the distance between the line segment AB and the point P was defined as an amount of warp α. Also, as illustrated in Figure 6, a point R on a curved line CD was determined so that, among line segments extending perpendicularly to the line segment CD from an arbitrary point on the curved line CD between the points C and D on the surface of the SiC substrate 10, the distance of the line segment was the longest (for example, in Figure 6, there are points such as points R and O as arbitrary points on the curved line CD, and among the line segments extending perpendicularly to the line segment CD from respective points, the line segment extending from the point R is the longest). Then, the distance between the line segment CD and the point R was defined as an amount of warp β. The average value of these amounts of warp α and β was defined as the amount of warp of the SiC substrate. The results were as shown in Table 1. The amount of warp can be measured by the above-mentioned measurement method even where the SiC substrate 10 is warped in a convex shape or in a concave shape.

### (7) Measurement of N Concentration and Rare Earth Element Concentration in Heat-Treated Layer

The center of the (0001) plane of the SiC substrate was determined to be an evaluation location, and was subjected to dynamic secondary ion mass spectrometry (D-SIMS). IMS-7f manufactured by CAMECA SAS was used as the apparatus for analysis of the rare earth element (Y in the present example), and measurement was performed with a primary ion species of O₂⁺ and at an acceleration voltage of 11.0 kV. IMS-7f manufactured by CAMECA SAS was used as the apparatus for analysis of N, and measurement was performed with a primary ion species of Cs⁺ and at an acceleration voltage of 15.0 kV. Thus, the rare earth element concentration C_{RE} (atoms/cm³) and the N concentration C_{N} (atoms/cm³) were measured. The results were as shown in Table 1.

### (8) Evaluation of Biaxial Orientation Property of Heat-Treated Layer

Inverse pole figure mapping was measured using the EBSD (Electron Back Scatter Diffraction Patterns) method for the surface (plate surface) and section orthogonal to the plate surface of the resultant heat-treated layer under the following conditions to find the tilt angle distribution to be 0.01° or less for both the approximate normal direction and the approximate plate surface direction, and therefore the heat-treated layer was determined to be a biaxially oriented SiC layer oriented along the c-axis and the a-axis, and was determined to have the same off angle as that of the SiC single crystal substrate.

### <Conditions for EBSD Measurement>

· Measurement apparatus: a SEM (manufactured by Hitachi High-Technologies Corporation, SU-5000) equipped with an Electron Back Scatter Diffraction apparatus (EBSD) (manufactured by Oxford Instruments, Nordlys Nano)
· Acceleration voltage: 15 kv
· Spot intensity: 70
· Working distance: 22.5 mm
· Step size: 0.5 µm
· Tilt angle of sample: 70°
· Measurement program: Aztec (version 3.3)

### Example 2

A SiC substrate was produced and evaluated as in Example 1 except that the flow speed of argon was set to 45 L/min and the flow speed of nitrogen was set to 5 L/min in (2). The resultant heat-treated layer was confirmed to be a biaxially oriented SiC layer. The results were as shown in Table 1.

### Example 3

A SiC substrate was produced and evaluated as in Example 1 except that the flow speed of argon was set to 90 L/min and the flow speed of nitrogen was set to 10 L/min in (2). The resultant heat-treated layer was confirmed to be a biaxially oriented SiC layer. The results were as shown in Table 1.

### Example 4

A SiC substrate was produced and evaluated as in Example 1 except that the flow speed of argon was set to 5 L/min and the flow speed of nitrogen was set to 0.5 L/min in (2). The resultant heat-treated layer was confirmed to be a biaxially oriented SiC layer. The results were as shown in Table 1.

### Example 5

A SiC substrate was produced and evaluated as in Example 1 except that a raw material powder containing 91.7% by weight of a commercially available β-SiC fine powder (volume-based D50 particle size: 0.7 µm) and 8.3% by weight of an yttrium oxide powder (volume-based D50 particle size: 0.1 µm) was used in (1). The resultant heat-treated layer was confirmed to be a biaxially oriented SiC layer. The results were as shown in Table 1.

### Example 6

A SiC substrate was produced and evaluated as in Example 1 except that a raw material powder containing 95.2% by weight of a commercially available β-SiC fine powder (volume-based D50 particle size: 0.7 µm) and 4.8% by weight of an yttrium oxide powder (volume-based D50 particle size: 0.1 µm) was used in (1). The resultant heat-treated layer was confirmed to be a biaxially oriented SiC layer. The results were as shown in Table 1.

### Example 7

A SiC substrate was produced and evaluated as in Example 1 except that a raw material powder containing 93.0% by weight of the commercially available β-SiC fine powder (volume-based D50 particle size: 0.7 µm), and 7.0% by weight of the yttrium oxide powder (volume-based D50 particle size: 0.1 µm) was used in (1). The resultant heat-treated layer was confirmed to be a biaxially oriented SiC layer. The results were as shown in Table 1.

### Example 8 (Comparison)

A SiC substrate was produced and evaluated as in Example 1 except that the flow speed of argon was set to 2.7 L/min and the flow speed of nitrogen was set to 0.3 L/min in (2). The resultant heat-treated layer was confirmed to be a biaxially oriented SiC layer. The results were as shown in Table 1.

### Example 9 (Comparison)

A SiC substrate was produced and evaluated as in Example 1 except that the flow speed of argon was set to 0.9 L/min and the flow speed of nitrogen was set to 0.1 L/min. in (2). The resultant heat-treated layer was confirmed to be a biaxially oriented SiC layer. The results were as shown in Table 1.

### [Table 1]

**Table 1**

| | Flow speed of argon (L/min) | Flow speed of nitrogen (L/min) | Difference of Raman shift value kₘₐₓ-kₘᵢₙ (cm⁻¹) | Amount of warp (µm) | N concentration C_{N} (atoms/cm³) | Rare earth element concentration C_{RE} (atoms/cm³) | Type of rare earth element |
|---|---|---|---|---|---|---|---|
| Ex. 1 | 4.5 | 0.5 | 0.45 | 19.7 | 5.1×10¹⁸ | 8.5×10¹⁴ | Y |
| Ex. 2 | 45 | 5 | 0.22 | 10.8 | 6.8×10¹⁸ | 7.1×10¹⁴ | Y |
| Ex. 3 | 90 | 10 | 0.17 | 2.4 | 7.2×10¹⁸ | 7.6×10¹⁴ | Y |
| Ex. 4 | 5 | 0.5 | 0.43 | 24.6 | 4.4×10¹⁸ | 8.4×10¹⁴ | Y |
| Ex. 5 | 4.5 | 0.5 | 0.48 | 27.8 | 5.6×10¹⁸ | 9.6×10¹³ | Y |
| Ex. 6 | 4.5 | 0.5 | 0.47 | 28.3 | 5.3×10¹⁸ | 5.7×10¹⁵ | Y |
| Ex. 7 | 4.5 | 0.5 | 0.46 | 18.8 | 6.9×10¹⁸ | 7.9×10¹⁴ | Ce |
| Ex. 8* | 2.7 | 0.3 | 0.53 | 41.1 | 7.0×10¹⁸ | 8.2×10¹⁴ | Y |
| Ex. 9* | 0.9 | 0.1 | 0.87 | 53.5 | 5.9×10¹⁸ | 9.1×10¹⁴ | Y |

| | | | | | | | |
|---|---|---|---|---|---|---|---|
| * indicates a comparative example. | | | | | | | |

## Claims

1. A SiC substrate comprising a biaxially oriented SiC layer,
wherein, in a Si surface and a C surface of the SiC substrate, a difference between a maximum value kₘₐₓ and a minimum value kₘᵢₙ of a Raman shift value is 0.50 cm⁻¹ or less, and
wherein, the Raman shift value is obtained by, in the Si surface of the SiC substrate, measuring the Raman shift value indicating a peak corresponding to a transverse acoustic branch of a Raman spectrum at 1 mm intervals on two straight lines passing through a central point of the Si surface and being orthogonal to each other, and, in the C surface of the SiC substrate, measuring the Raman shift value indicating a peak corresponding to a transverse acoustic branch of a Raman spectrum at 1 mm intervals on two straight lines passing through a central point of the C surface and being orthogonal to each other.

2. The SiC substrate according to claim 1, wherein the difference between the maximum value kₘₐₓ and the minimum value kₘᵢₙ is 0.20 cm⁻¹ or less.

3. The SiC substrate according to claim 1 or 2, wherein a N concentration of the biaxially oriented SiC layer is 5.0 × 10¹⁸ atoms/cm³ or more.

4. The SiC substrate according to claim 1 or 2, wherein a rare earth element concentration of the biaxially oriented SiC layer is 1.0 × 10¹⁴ to 5.0 × 10¹⁵ atoms/cm³.

5. A SiC composite substrate comprising:
a SiC single crystal substrate; and
the SiC substrate according to claim 1 or 2 on the SiC single crystal substrate.
